# EUROPÄISCHE PATENTSCHRIFT

(11) **EP 1 518 902 B1**
(45) Veröffentlichungstag und Bekanntmachung des Hinweises auf die Patenterteilung: **01.01.2014**
(21) Anmeldenummer: 04020002.4
(22) Anmeldetag: 24.08.2004
(51) Int. Cl.: C08L 83/06, C08G 77/16, C08L 83/12

(54) **Verwendung von hydroxyfunktionellen Polyalkylorganosiloxanen als Lösungsmittel für kationische Photoinitiatoren für die Verwendung in strahlenhärtbaren Siliconen**
Use of polyorganosiloxanes comprising hydroxyl functions as a solvent for a cationic photoinitiator in radiating curable silicones
Utilisation de polyorganosiloxanes ayant une fonction hydroxylique comme solvant pour des photoinitiateurs cationiques dans le durcissement par irradiation de silicones

(30) Priorität: 06.09.2003 DE 10341137
(43) Veröffentlichungstag der Anmeldung: 30.03.2005
(73) Patentinhaber: Evonik Degussa GmbH, 45128 Essen (DE)
(72) Erfinder: Oestreich, Sascha, Dr., 45279 Essen (DE); Döhler, Hardi, 45525 Hattingen (DE)

(56) Entgegenhaltungen:
- EP-A- 0 334 068
- EP-A- 1 020 479
- EP-A- 1 136 533
- PATENT ABSTRACTS OF JAPAN Bd. 1998, Nr. 03, 27. Februar 1998 (1998-02-27) & JP 09 291132 A (TOYO INK MFG CO LTD), 11. November 1997 (1997-11-11)
- DATABASE WPI Section Ch, Week 198805 Derwent Publications Ltd., London, GB; Class A21, AN 1988-032053 XP002316602 & JP 62 290769 A (HITACHI CHEM CO LTD) 17. Dezember 1987 (1987-12-17)

## Beschreibung

Die vorliegende Erfindung betrifft Lösungen von Diaryljodoniumsalzen in hydroxyfunktionellen Poly-alkylorganosiloxanen sowie deren Verwendung als Photoinitiatoren in kationisch strahlenhärtbaren Siliconen.

Seit den 80er Jahren sind kationisch strahlenhärtende abhäsive Beschichtungsmassen im Markt bekannt. Diese bestehen aus reaktiven Gruppen aufweisende Organopolysiloxanen, die unter UV-Strahlung nach einem kationischen Härtungsmechanismus aushärten. Diese reaktiven Gruppen können Epoxygruppen, Vinylethergruppen, Alkenyloxygruppen wie Vinyloxygruppen oder Propenyloxygruppen sein. Solche Substanzen sind beispielsweise in US-A-5 057 549, US-A-5 231 157, US-A-4 421 904, US-A-4 547 431, US-A-4 952 657, US-A-5 217 805, US-A-5 279 860, US-A-5 340 898, US-A-5 360 833, US-A-5 650 453, US-A-5 866 261 und US-A-5 973 020 beschrieben.

Die kationische Photopolymerisation ist ein schneller, effizienter und umweltschonender Weg, um kationisch polymerisierbare Monomere zu härten. Besonders effiziente Photoinitiatoren stellen Diaryliodonium- (I) und Triarylsulfoniumsalze (II) dar.

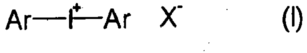

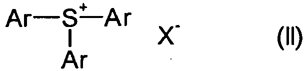

X⁻= BF₄⁻, PF6⁻, AsF₆⁻, SbF₆⁻

worin Ar für gleiche oder verschiedene aromatische Reste steht, die gegebenenfalls Heteroatome und/oder weitere substituierende Reste enthalten können.

Insbesondere Diaryliodoniumsalze (I) sind aus der Patentliteratur bekannt (GB-A-1 516 352, US-A-4 279 717, EP-A-0 334 056, US-A-5 468 890) und werden als Photoinitiatoren zur Polymerisation von kationisch polymerisierbaren Substanzen verwendet.

Eine wichtige Voraussetzung für die Nutzbarkeit der Photoinitiatoren ist ihre Mischbarkeit in den kationisch strahlenhärtbaren Organopolysiloxanen. Um diese zu gewährleisten, werden die Photoinitiatoren mit einen hydrophoben Rest hergestellt oder modifiziert, wie z. B. in US-A-4 310 469, US-A-6 365 643 und US-A-6 380 277 beschrieben.

Solche Photoinitiatoren sind in der Reinform jedoch Feststoffe oder zumindest wachsartige oder viskose Verbindungen und damit nur schwer in kationisch strahlenhärtbaren Organopolysiloxane einzuarbeiten. Zum Beispiel hat der im Markt erhältliche kationische Photoinitiator Bis-(dodecylphenyl)iodonium hexafluoroantimonat (III), 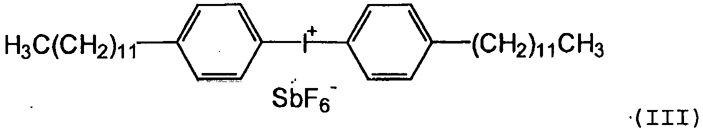 bei Raumtemperatur eine wachsartige Konsistenz.

Um eine leichte Einarbeitbarkeit solcher Photoinitiatoren in die kationisch strahlenhärtbaren Massen zu gewährleisten, werden die Photoinitiatoren in der Regel bereits in gelöster Form angeboten. Hierzu werden Lösemittel wie Toluol, Xylol, Isopropanol, Propylenglycol, Alkylphenole, Propylencarbonat, Glycidether und Butyrolacton verwendet.

Eine wichtige Voraussetzung für die Nutzbarkeit solcher Lösemittel ist, dass darin die kationischen Photoinitiatoren klar löslich und mit den kationisch strahlenhärtbaren Organopolysiloxanen klar mischbar sind. Mit beispielsweise Propylencarbonat, Ethylenglykol, Propylenglykol sind die häufig sehr hydrophoben kationisch härtbaren Organopolysiloxane in der Regel jedoch nicht klar mischbar. Andere Lösungsmittel wie z. B. C₁₂/C₁₄-Glycidether sind umweltgefährdend.

Insbesondere niedermolekulare, leichtflüchtige Verbindungen sind als Lösemittel für die kationischen Photoinitiatoren nur eingeschränkt geeignet, da sie die Umwelt durch Gerüche und/oder flüchtige Lösungsmittelbestandteile (VOC "volatile organic compounds") belasten und die Gefahr der Bildung von explosiven Gasgemischen in sich bergen.

Um eine Belastung der Umwelt durch Gerüche und/oder VOCs zu vermeiden, ist man bestrebt, hochsiedende Lösemittel zu verwenden, die zusätzlich über funktionelle Gruppen in die kationisch härtbare Beschichtung eingebaut werden können und damit in der gehärteten Silicontrennbeschichtung nicht als migrierfähiger Bestandteil verbleiben. Solche hochsiedenden Lösemittel können zum Beispiel Alkylphenole oder Alkylepoxide sein, wie sie in EP-A-0 522 703 beschrieben werden.

Insbesondere im Falle von Beschichtungen, die aus Epoxygruppen aufweisenden Organopolysiloxanen hergestellt werden, wird jedoch beobachtet, dass polare Lösemittel, wie Isopropanol, Propylenglycol und Alkylphenole die Trennwirkung der Organopolysiloxanbeschichtung negativ beeinflussen können. Zum Beispiel beschreibt US-A-4 954 364 den Zusatz von Alkylphenolen zu Epoxygruppen aufweisenden Organopolysiloxanen als "controlled release additiv" (CRA), um die trennende Eigenschaft der Organopolysiloxanbeschichtung gezielt zu verschlechtern. Schon der Zusatz von 0,1 Teilen Nonylphenol zum Epoxygruppen aufweisenden Organopolysiloxan bewirkt eine Verdopplung der Trennkraft gegenüber einer Nonylphenol-freien Beschichtung. Die Trennkraft (oder Trennwert) ist die Kraft, die benötigt wird, um das jeweilige Klebeband vom Untergrund abzuziehen. In der Regel wird aber durch eine Organopolysiloxanbeschichtung eine möglichst gute Trennwirkung, d. h. geringe Trennkraft, angestrebt.

Es ist daher wünschenswert, hochsiedende Lösemittel zu finden, die die Umwelt nicht durch Gerüche und/oder flüchtige Lösungsmittelbestandteile (VOC "volatile organic compounds") belasten und die Trennwirkung von Organopolysiloxanbeschichtungen nicht negativ beeinflussen.

Eine weitere wichtige Voraussetzung für die Nutzbarkeit solcher Lösemittel ist, dass die Mischungen aus Lösemittel und Photoinitiator mindestens sechs Monate Lagerstabilität zeigen. Es ist also wünschenswert, Lösemittel zu finden, die den kationischen Photoinitiator klar lösen und die eine Lagerstabilität von mindestens sechs Monaten aufweisen.

Bei der Darstellung von kationischen Photoinitiatoren, wie sie in den Anmeldungen US-A-6 365 643 und US-A-6 380 277 beschrieben sind, werden teilweise toxische, ätzende und/oder umweltgefährliche Substanzen, wie zum Beispiel Isocyanate, Säurechloride oder Chlorsilane eingesetzt. Diese Substanzen werden aus Gründen der Reaktionsführung im Überschuss eingesetzt, der dann wegen der thermischen Labilität der Iodoniumsalze anschließend nur unzureichend destillativ entfernt werden kann.

Es ist daher weiterhin wünschenswert, Lösemittel zu finden, die zusammen mit den verbleibenden Überschüssen zu unschädlichen, polymeren Substanzen abreagieren.

Der vorliegenden Erfindung liegt daher die Aufgabe zugrunde, Lösemittel für insbesondere Diaryliodoniumsalze als Photoinitiatoren zur kationischen Härtung von strahlenhärtbaren Organopolysiloxanen bereitzustellen, die klar mischbar mit den kationisch härtbaren Organopolysiloxanen sind und die eine Lagerstabilität von mindestens sechs Monaten aufweisen, die die Belastung der Umwelt durch Gerüche und/oder flüchtige Lösemittelbestandteile (VOC "volatile organic compounds") verringern, die Trennwirkung von Organopolysiloxan-basierenden Beschichtungen nicht negativ beeinflussen, in die Beschichtung einpolymerisierbar sind und mit Überschüssen reaktiver Substanzen zu unschädlichen, polymeren Verbindungen reagieren können.

Überraschenderweise wurde gefunden, dass die vorgenannte Aufgabe gelöst wird durch die Verwendung von hydroxyfunktionellen Polyalkylorganosiloxanen als Lösungsmittel.

Ein Gegenstand der Erfindung ist daher die Lösung von Diaryljodoniumsalzen in hydroxyfunktionellen Polyalkylorganosiloxanen der allgemeinen Formel (IV) 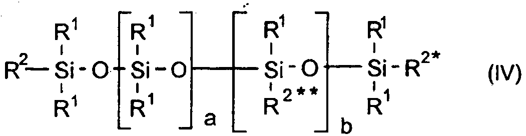 wobei
- a: 0 bis 200 ist,
- b: 0 bis 50 ist,
- R¹: im Molekül gleich oder verschieden ist und Alkylreste mit 1 bis 4 Kohlenstoffatomen bedeutet,
- R², R^{2*}, R^{2**}: gleich oder verschieden die folgende Bedeutung haben
- R^{2a}: unabhängig voneinander ausgewählte, gegebenenfalls substituierte Alkylreste mit 1 bis 20 Kohlenstoffatomen, gegebenenfalls substituierte Aryl- oder Aralkylreste,
- R^{2b}: unabhängig voneinander ausgewählte Reste der allgemeinen Formel -R³ [-O-(CₙH₂nO-)ₓH]_{z}
wobei
R³ ein gegebenenfalls substituierter, gegebenenfalls substituierter und/oder Etherbrücken enthaltender, z+1-wertiger Kohlenwasserstoffrest mit 2 bis 20 Kohlenstoffatomen, ein gegebenenfalls substituierter und/oder Etherbrücken enthaltender Arylrest oder Aralkylrest ist,
n 2, 3 oder 4 ist,
x 0 bis 100 ist,
z 1 bis 6 ist,
mit der Maßgabe, dass im durchschnittlichen Molekül jeweils mindestens ein Rest R², R^{2*}, R^{2**} die Bedeutung R^{2b} hat.

In einer bevorzugten Ausführungsform der vorliegenden Erfindung sind die hydroxyfunktionellen Polyalkylorganosiloxane dadurch gekennzeichnet, dass
- a: für eine Zahl im Bereich 5 bis 100, insbesondere 5 bis 80,
- b: für eine zahl im Bereich 0 bis 10, insbesondere 0 bis 5,
- n: für eine Zahl im Bereich 2 bis 3,
- x: für eine Zahl im Bereich 0 bis 30, insbesondere 0 bis 10,
- z: für eine Zahl von 1 bis 3
steht.

Die Werte der Indices a, b und x stellen Mittelwerte dar, wobei die jeweiligen Inkremente statistisch oder blockweise verteilt im Molekül vorliegen können.

Im Molekülteil -R³[-O-(CₙH₂ₙO-)ₓH]_{z} kann "n" gleich oder verschieden einen oder mehrere der Werte von 2 bis 4 annehmen, wobei die Verteilung innerhalb des Wiederholungsbereichs "x" blockweise oder statistisch sein kann.

Besonders bevorzugt im Sinne der vorliegenden Erfindung sind hydroxyfunktionelle Polyalkylorganosiloxane, wobei in der allgemeinen Formel (IV) der Rest R¹ für einen Methylrest steht.

Beispiele für den Rest R^{2a} sind Alkylreste, wie der Methyl-, Ethyl-, Butyl-, Dodecyl- und/oder Hexadecylrest; Arylreste, wie der Phenyl- und/oder Naphtylrest und Aralkylreste, wie der (Methyl)ethylphenylrest.

Beispiele für den Rest R³ sind zweiwertige Alkylreste, wie -CH₂-, -(CH₂)₂-, -(CH₂)₃- -(CH₂)₄-, -(CH₂)₆-, -(CH₂)₁₀-, -CH₂CH₂CH(OCH₃)CH₂-; Arylreste, wie der Phenyl-, Naphtyl- oder Anthrylrest und Aralkylreste, wie 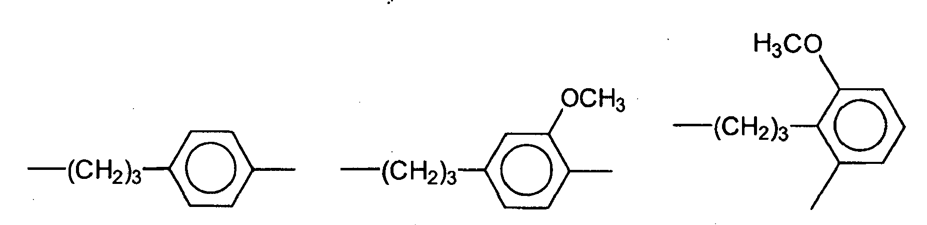 und Etherbrücken enthaltende Reste, wie

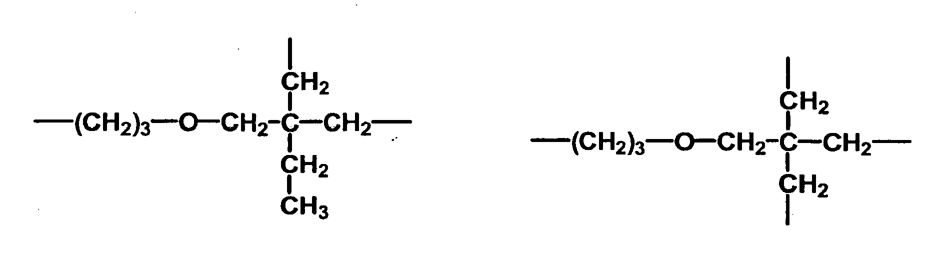

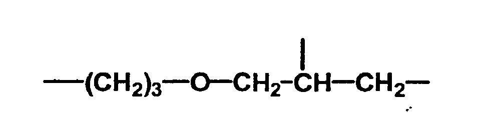

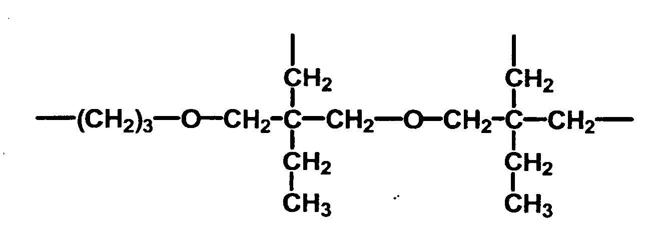

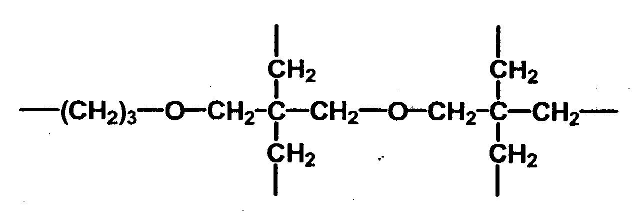

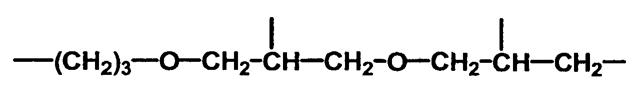

Besonders bevorzugte Beispiele für den Rest R³ sind -(CH₂)₃-, -(CH₂)₆-,

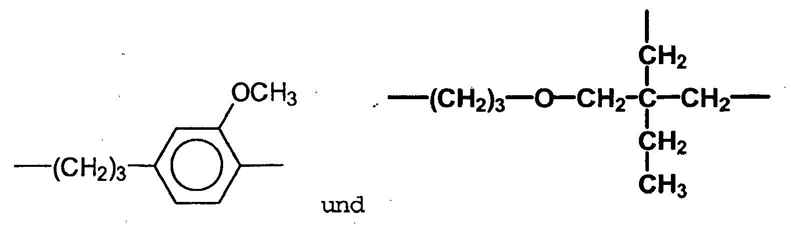

Beispiele für erfindungsgemäß verwendete hydroxyfunktionelle Polyalkylorganosiloxane sind

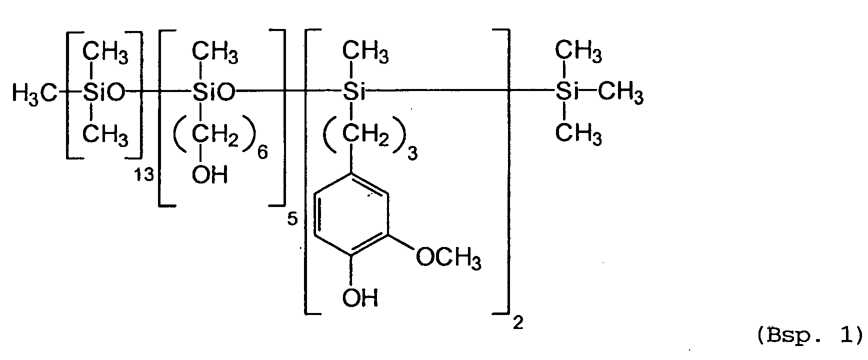

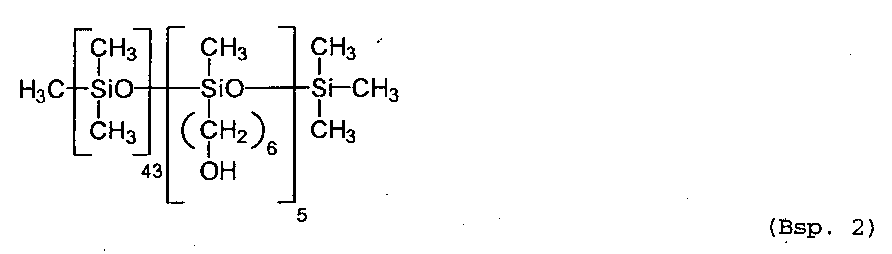

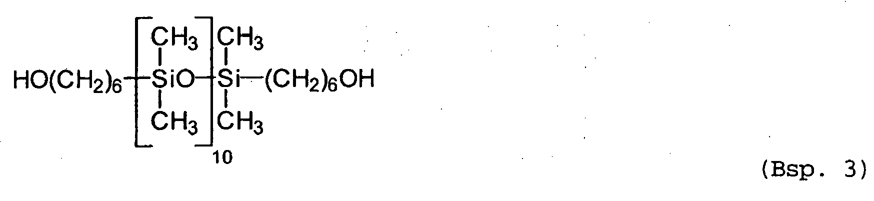

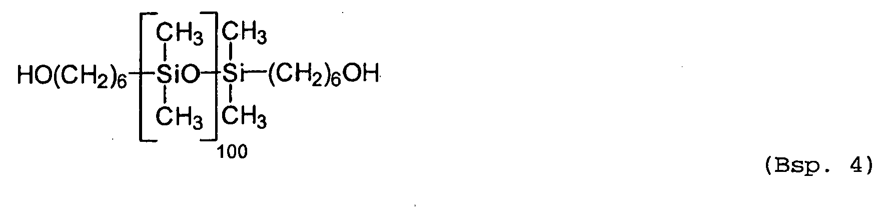

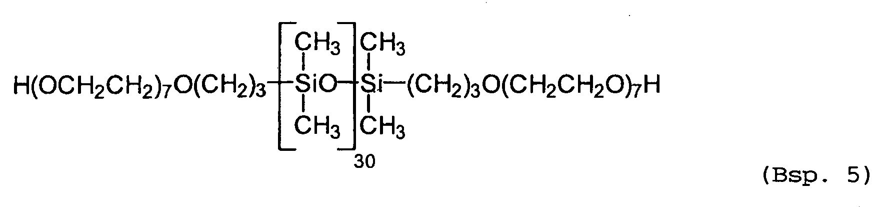

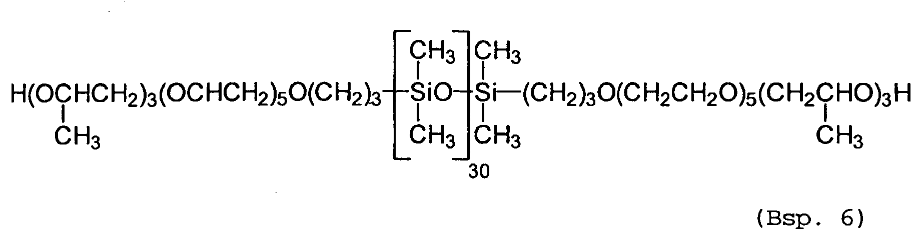

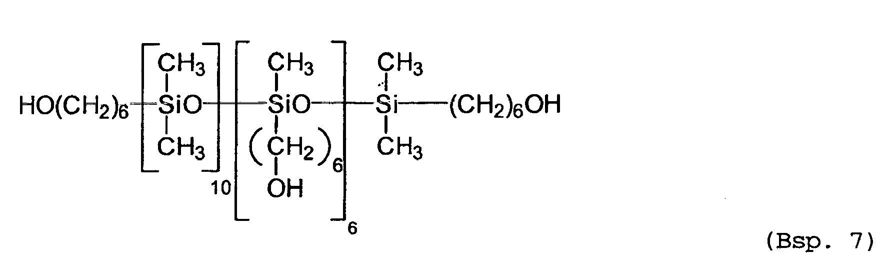

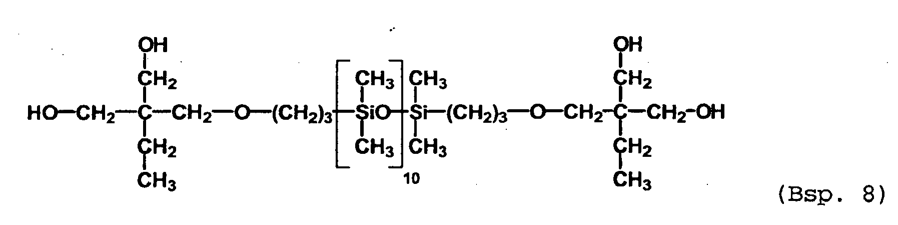

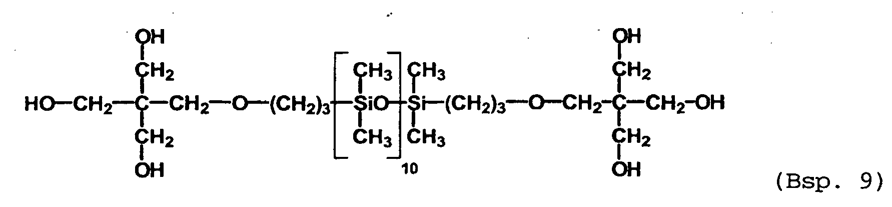

Kationische Photoinitiatoren im Sinne der vorliegenden Erfindung sind Diaryliodonium- (I) und Triarylsulfoniumsalze (II).

Beispiele für kationische Photoinitiatoren im Sinne der vorliegenden Erfindung können "J.V. Crivello und K. Dietliker, Photoinitiators for Free Radical Cationic & Anionic Photopolymerisation 2nd Edition, John Wiley and Sons, New York, 1998, p. 379 - 466" und US-A-6 365 643 entnommen werden. Die erfindungsgemäß bevorzugten kationischen Photoinitiatoren sind Diaryliodoniumsalze der allgemeinen Formel (V):

Ar-I⁺-Ar X⁻ (V)

worin
- I: für das Element Iod steht,
- Ar: für gleiche oder verschiedene aromatische Reste steht, die gegebenenfalls Heteroatome und/oder weitere substituierende Reste enthalten können
und
- X⁻: für ein Anion eines komplexen Metallsalzes oder einer starken Säure steht.

Besonders bevorzugte Beispiele für Diaryliodoniumsalze im Sinne der vorliegenden Erfindung sind

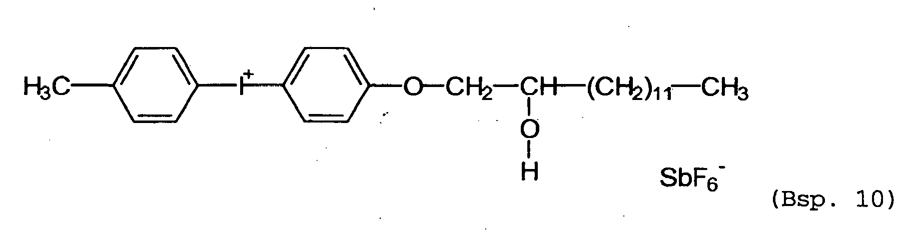

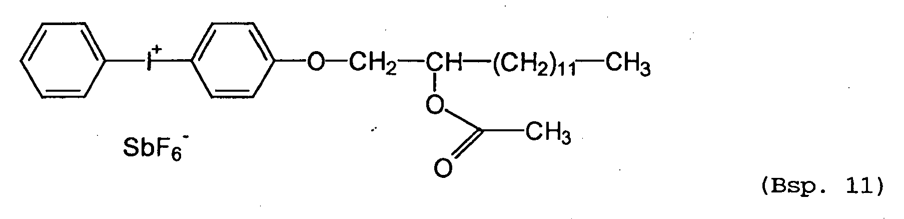

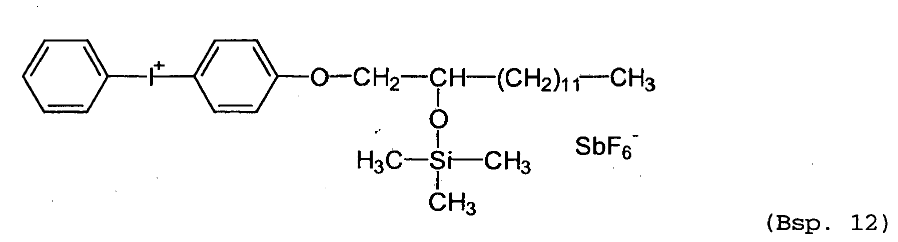

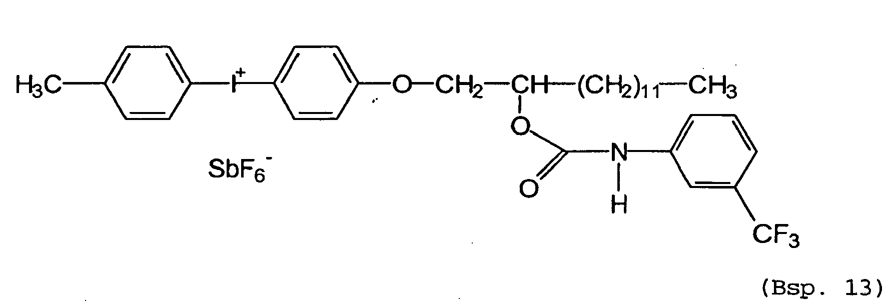

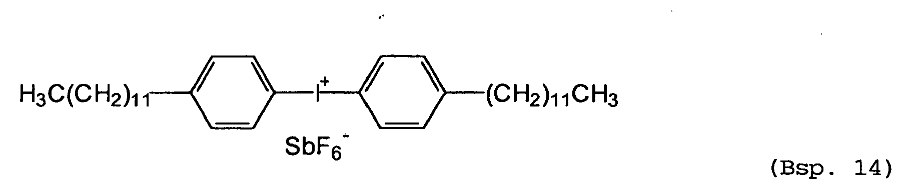

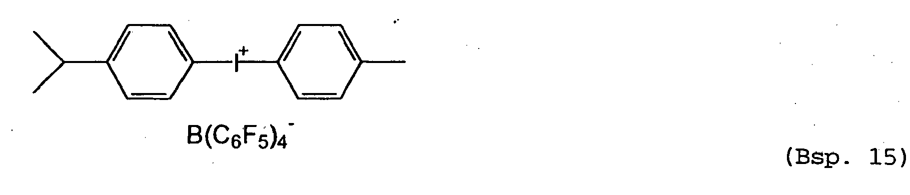

### Vergleichsversuche:

Das Lösungsverhalten der erfindungsgemäß verwendeten hydroxyfunktionellen Polyalkylorganosiloxane wird mit dem Lösungsverhalten nichterfindungsgemäßer Verbindungen verglichen. Dazu wurden jeweils 50 Gew.-% Lösungsmittel und 50 Gew.-% Diaryliodoniumsalz miteinander gemischt und die Lagerstabilität (180 Tage bei 25°C) der Mischung beobachtet. Die Ergebnisse sind in Tabelle 1 zusammengefasst:

**Tabelle 1:**

| **Lösungsmittel** | **Diaryliodoniumsalz** | **Lösung nach 1 Tag** | **Lösung nach 180 Tagen** |
|---|---|---|---|
| Toluol | Bsp. 10 | trübe | Zwei Phasen |
| Toluol | Bsp. 11 | klar | Zwei Phasen |
| Toluol | Bsp. 12 | klar | Zwei Phasen |
| Toluol | Bsp. 13 | klar | klar |
| Isopropanol | Bsp. 10 | klar | klar |
| Dodecylphenol | Bsp. 13 | klar | klar |
| Polyethylenglycol 200 | Bsp. 10 | klar | klar |
| Siliconöl 100 | Bsp. 12 | trübe | Zwei Phasen |
| C₁₂/C₁₄-Glycidether | Bsp. 14 | klar | klar |
| Propylencarbonat | Bsp. 14 | klar | klar |
| Bsp. 1 | Bsp. 10 | klar | klar |
| Bsp. 2 | Bsp. 13 | klar | klar |
| Bsp. 3 | Bsp. 13 | klar | klar |
| Bsp. 4 | Bsp. 15 | klar | klar |
| Bsp. 5 | Bsp. 14 | klar | klar |
| Bsp. 6 | Bsp. 11 | klar | klar |
| Bsp. 7 | Bsp. 13 | klar | klar |

Es zeigt sich, dass die erfindungsgemäß verwendeten hydroxyfunktionellen Polyalkylorganosiloxane Diaryliodoniumsalze klar lösen und auch noch nach 180 Tagen Lagerzeit stabile Lösungen ergeben.

Um die Belastung der Umwelt durch Gerüche und/oder flüchtige Lösemittelbestandteile (VOC "volatile organic compounds") zu ermitteln, wurden jeweils 4 Gew.-% einer Photoinitiatorlösung, bestehend aus 50 Gew.-% Lösungsmittel und 50 Gew.-% Photoinitiator, mit 96 Gew.-% eines cycloaliphatischen Epoxysilicones mit einer Viskosität von 125 mPas und einem Epoxywert von 3,5 % gemischt und dann mit einem Fünf-Rollen-Auftragswerk an einer Pilotanlage auf eine Standard-BOPP(Biorientierte Polypropylen)-Folie aufgebracht. Das Auftragsgewicht lag bei 1 g/m². Die Beschichtung wurde anschließend mit einer Mikrowellen angeregten UV-Lampe (Fusion, 120 W/cm) bei einer Geschwindigkeit von 20 m/min gehärtet.

Direkt nach dem Verlassen der UV-Lampe wurde der Geruch der beschichteten Folie bestimmt. Die Ergebnisse sind in Tabelle 2 zusammengefasst.

**Tabelle 2:**

| **Lösungsmittel** | **Diaryliodoniumsalz** | **Geruch** |
|---|---|---|
| Toluol | Bsp. 10 | Toluol (stark) |
| Toluol | Bsp. 11 | Toluol (stark) |
| Toluol | Bsp. 12 | Toluol (stark) |
| Toluol | Bsp. 13 | Toluol (stark) |
| Isopropanol | Bsp. 10 | Isopropanol |
| Dodecylphenol | Bsp. 13 | neutral |
| Polyethylengl ycol 200 | Bsp. 10 | neutral |
| Siliconöl 100 | Bsp. 12 | neutral |
| C₁₂/C₁₄-Glycidether | Bsp. 14 | stechend |
| Propylencarbo nat | Bsp. 14 | neutral |
| Bsp. 1 | Bsp. 10 | neutral |
| Bsp. 2 | Bsp. 13 | neutral |
| Bsp. 3 | Bsp. 13 | neutral |
| Bsp. 4 | Bsp. 15 | neutral |
| Bsp. 5 | Bsp. 14 | neutral |
| Bsp. 6 | Bsp. 11 | neutral |
| Bsp. 7 | Bsp. 13 | neutral |

Es zeigt sich, dass die erfindungsgemäß verwendeten hydroxyfunktionellen Polyalkylorganosiloxane gegenüber den nicht erfindungsgemäßen Lösemitteln, insbesondere Toluol und Isopropanol, einen deutlich verbesserten Geruch aufweisen.

Die hydroxyfunktionellen Polyalkylorganosiloxane sind in der Lage nach folgendem Mechanismus (VI)

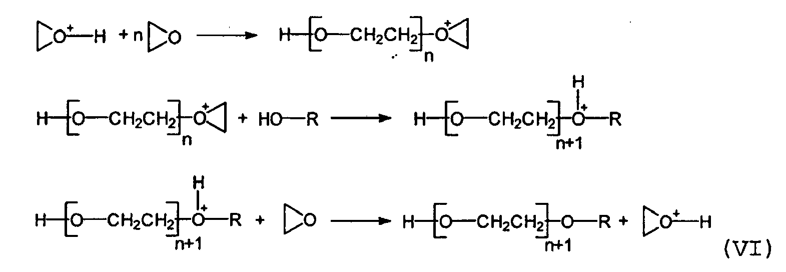

(J. V. Crivello, S. Liu, Journal of Polymer Science: Part A: Polymer Chemistry, Vol. 38, 389-401 (2000) ) bei der kationischen Polymerisation von kationisch polymerisierbaren Massen - hier Epoxiden - als Kettenüberträger zu wirken und somit während der kationischen Härtung in die Beschichtung einzuhärten.

Dem Fachmann ist bekannt, dass die hydroxyfunktionellen Polyalkylorganosiloxane mit reaktiven Verbindungen, wie Isocyanaten, Säurechloriden und/oder Chlorsilanen zu unschädlicheren Verbindungen reagieren können. Zum Beispiel kann nach der Herstellung des Diaryliodoniumsalzes (Bsp. 13) das hydroxyfunktionelle Polyalkylorganosiloxan (Bsp. 2) mit dem überschüssigen (Trifluormethyl)phenylisocyanat zu einem unschädlichen Urethan abreagieren.

Um die Auswirkung des verwendeten Lösemittels auf die Trenneigenschaften von Organopolysiloxan basierenden Trennbeschichtungen zu bestimmen, wurden jeweils 4 Gew.-% einer Photoinitiatorlösung, bestehend aus 50 Gew.-% Lösungsmittel und 50 Gew.-% Photoinitiator, mit 96 Gew.-% eines cycloaliphatischen Epoxysilicones mit einer Viskosität von 300 mPas (25°C) und einem Epoxywert von 1,36 % gemischt. Die Mischung wurde auf Eintrübung als Zeichen der Unverträglichkeiten bewertet. Die Mischung wurde dann mit einem Fünf-Rollen-Auftragswerk an einer Pilotanlage auf eine Standard-BOPP-Folie aufgebracht. Das Auftragsgewicht lag bei 0,5 bis 1,0 g/m². Die Beschichtung wurde anschließend mit einer Mikrowellen angeregten UV-Lampe (Fusion, 120 W/cm) bei einer Geschwindigkeit von 20 m/min gehärtet.
(A) Der Trennwert der Trennbeschichtungen wurde nach der FINAT Testmethode Nr. 10 bestimmt. Dazu wird das handelsübliche Klebeband (25 mm breit) TESA® 7476 der Firma Beiersdorf eingesetzt. Zur Messung der Abhäsivität werden diese Klebebänder auf die Trennbeschichtung aufgewalzt und anschließend bei 40°C unter einem Gewicht von 70 g/cm² gelagert. Nach 24 h wird die Kraft gemessen, die benötigt wird, um das jeweilige Klebeband mit einer Geschwindigkeit von 30 cm/min unter einem Schälwinkel von 180° vom Untergrund abzuziehen. Diese Kraft wird als Trennkraft oder Trennwert bezeichnet.
(B) Die Bestimmung der Restklebkraft erfolgt weitestgehend gemäß der FINAT Testmethode Nr. 11. Hierzu wurde das Klebeband TESA® 7475 der Firma Beiersdorf auf die Trennbeschichtung aufgewalzt und anschließend bei 40°C unter einem Gewicht von 70 g/cm² gelagert. Nach 24 h wurde das Klebeband vom Trennsubstrat getrennt und auf einem definierten Untergrund (Stahlplatte) aufgewalzt. Nach einer Minute wurde die Kraft gemessen, die benötigt wurde, um das Klebeband mit einer Geschwindigkeit von 30 cm/min unter einem Schälwinkel von 180° vom Untergrund abzuziehen. Der so gemessene Wert wurde durch den Wert geteilt, den ein unbehandeltes Klebeband unter ansonsten gleichen Testbedingungen ergab. Das Ergebnis wurde als Restklebkraft bezeichnet und in der Regel in Prozent angegeben. Werte über 80 % gelten dem Fachmann als ausreichend und sprechen für eine gute Aushärtung.

Die Ergebnisse sind in Tabelle 3 zusammengefasst.

**Tabelle 3:**

| **Nr** | **Lösungsmittel** | **Diaryliodoniumsalz** | **Mischung mit Epoxysilicon** | **Trennkraft (cN/inch) Methode (A)** | **Restklebkraft (%) Methode (B)** |
|---|---|---|---|---|---|
| 1 | Toluol | Bsp. 10 | trüb | 40 | 70 |
| 2 | Toluol | Bsp. 11 | trüb | 35 | 72 |
| 3 | Toluol | Bsp. 12 | klar | 55 | 85 |
| 4 | Toluol | Bsp. 13 | klar | 57 | 88 |
| 5 | Isopropanol | Bsp. 10 | trüb | 45 | 69 |
| 6 | Dodecylphenol | Bsp. 13 | klar | 92 | 89 |
| 7 | Polyethylenglycol 200 | Bsp. 10 | trüb | 47 | 73 |
| 8 | Siliconöl 100 | Bsp. 12 | trüb | 40 | 65 |
| 9 | C₁₂/C₁₄-Glycidether | Bsp. 14 | klar | 55 | 88 |
| 10 | Propylencarbonat | Bsp. 14 | trüb | 52 | 90 |
| 11 | Bsp. 1 | Bsp. 14 | klar | 56 | 87 |
| 12 | Bsp. 2 | Bsp. 13 | klar | 58 | 88 |
| 13 | Bsp. 3 | Bsp. 13 | klar | 57 | 90 |
| 14 | Bsp. 4 | Bsp. 15 | klar | 52 | 91 |
| 15 | Bsp. 5 | Bsp. 14 | klar | 50 | 89 |
| 16 | Bsp. 6 | Bsp. 14 | klar | 59 | 91 |
| 17 | Bsp. 7 | Bsp. 13 | klar | 58 | 90 |

Niedrige Trennwerte sowie eine niedrige Restklebkraft deuten auf eine schlechte Aushärtung der Silicone oder migrierfähige Bestandteile in der Beschichtung hin. Dies ist bei den Versuchen Nr. 1, 2, 5 und 7 wegen der teilweisen Unverträglichkeit des Photokatalysators mit dem Epoxysilicon und im Versuch Nr. 8 wegen des mirgierfähigen Lösungsmittels (Siliconöl 100) der Fall.

Trennwerte um 50-60 cN/in mit gleichzeitig guter Restklebkraft deuten auf eine qualitativ gute Trennbeschichtung. Die Trenneigenschaften von Organopolysiloxan-basierenden Trennbeschichtungen werden durch die Verwendung von Hydroxyalkylpolydimethylsiloxanen als Lösungsmittel für Diaryliodoniumsalze gegenüber dem eingangs erwähnten Stand der Technik nicht negativ beeinflusst.

Die erfindungsgemäß verwendeten Hydroxyalkylpolydimethylsiloxane eignen sich als polymere Lösemittel für Photoinitiatoren für die Polymerisation von kationisch polymerisierbaren Organopoly-siloxanen.

## Patentansprüche

1. Lösung von Diaryljodoniumsalzen in hydroxyfunktionellen Polyalkylorganosiloxanen der allgemeinen Formel (IV) 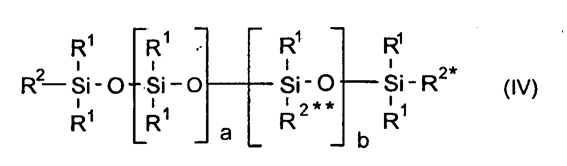 worin
a 0 bis 200 ist,
b 0 bis 50 ist,
R¹ im Molekül gleich oder verschieden ist und Alkylreste mit 1 bis 4 Kohlenstoffatomen bedeutet,
R², R^{2*} , R^{2**} gleich oder verschieden die folgende Bedeutung haben
R^{2a} unabhängig voneinander ausgewählte, gegebenenfalls substituierte Alkylreste mit 1 bis 20 Kohlenstoffatomen, gegebenenfalls substituierte Aryl- oder Aralkylreste,
R^{2b} unabhängig voneinander ausgewählte Reste der allgemeinen Formel -R³[-O-(CₙH₂ₙO-)ₓH]_{z}
wobei
R³ ein gegebenenfalls substituierter, gegebenenfalls substituierter und/oder Etherbrücken enthaltender, z+1-wertiger Kohlenwasserstoffrest mit 2 bis 20 Kohlenstoffatomen, ein gegebenenfalls substituierter und/oder Etherbrücken enthaltender Aryloder Aralkylrest ist,
n 2, 3 oder 4 ist,
x 0 bis 100 ist,
z 1 bis 6 ist,
mit der Maßgabe, dass im durchschnittlichen Molekül jeweils mindestens ein Rest R², R^{2*}, R^{2**} die Bedeutung R^{2b} hat.

2. Lösung gemäß Anspruch 1, **dadurch gekennzeichnet, dass**
a für eine Zahl im Bereich 5 bis 100, insbesondere 5 bis 80,
b für eine Zahl im Bereich 0 bis 10, insbesondere 0 bis 5,
n für eine Zahl im Bereich 2 bis 3,
x für eine Zahl im Bereich 0 bis 30, insbesondere 0 bis 10,
z für eine Zahl von 1 bis 3
steht.

3. Lösung gemäß Anspruch 1 und 2, **dadurch gekennzeichnet, dass** der Rest R¹ für einen Methylrest steht.

4. Lösung gemäß Ansprüchen 1 bis 3, **dadurch gekennzeichnet, dass** der Rest R^{2a} mindestens ein Rest ist ausgesucht aus der Gruppe Methyl-, Ethyl-, Butyl-, Dodecyl-, Hexadecylrest, Arylreste, Phenyl-, Naphtylrest und/oder (Methyl)ethylphenylrest.

5. Lösung gemäß Ansprüchen 1 bis 4, **dadurch gekennzeichnet, dass** der Rest R³ mindestens ein Rest ist ausgesucht aus der Gruppe -CH₂-, -(CH₂)₂-, -(CH₂)₃-, -(CH₂)₄-, -(CH₂)₆- , -(CH₂)₁₀-, -CH₂CH₂CH(OCH₃)CH₂-, Phenyl-, Naphtyl- oder Anthrylrest und Aralkylreste, wie 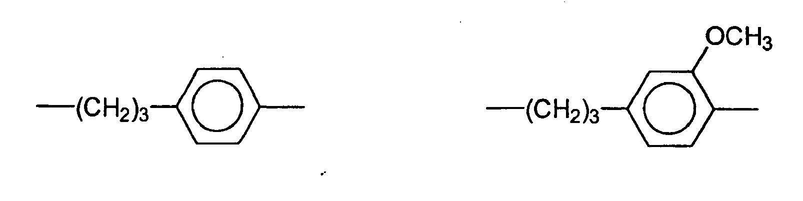 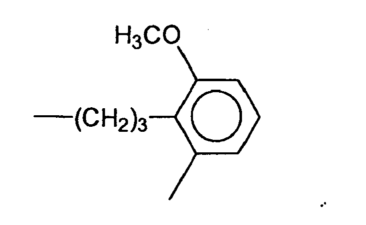 und Etherbrücken enthaltende Reste, wie

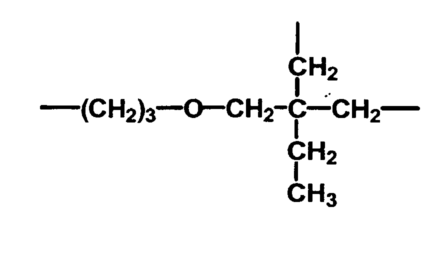

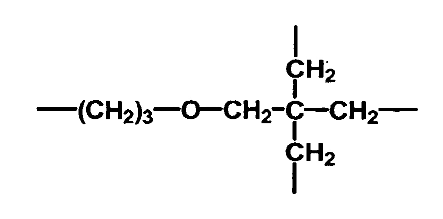

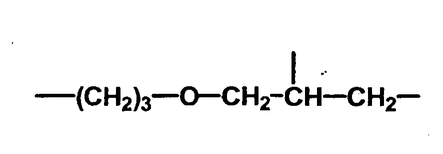

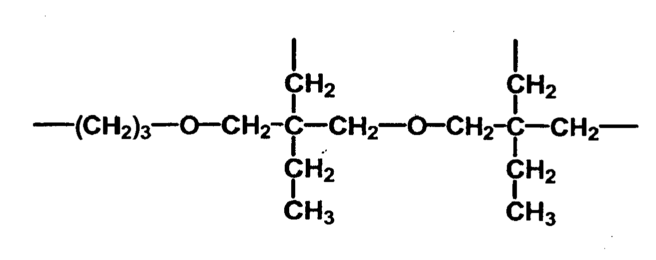

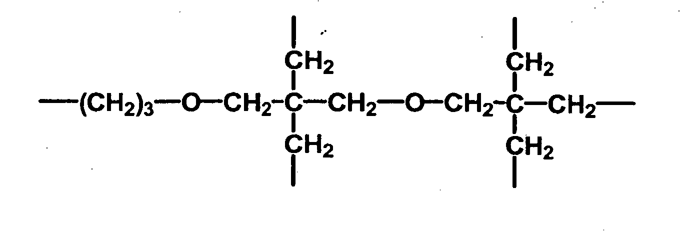

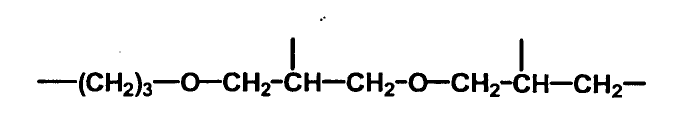

6. Lösung gemäß Ansprüchen 1 bis 5, **dadurch gekennzeichnet, dass** die Diaryljodoniumsalze eine Verbindung ausgesucht aus der Gruppe 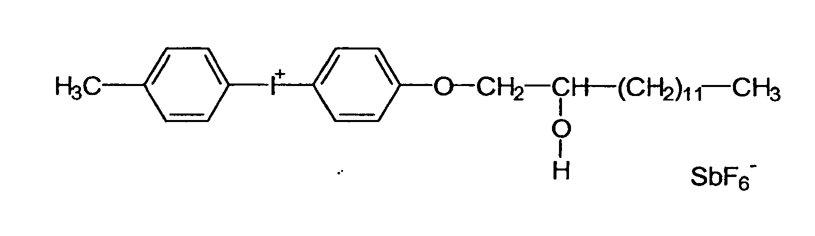 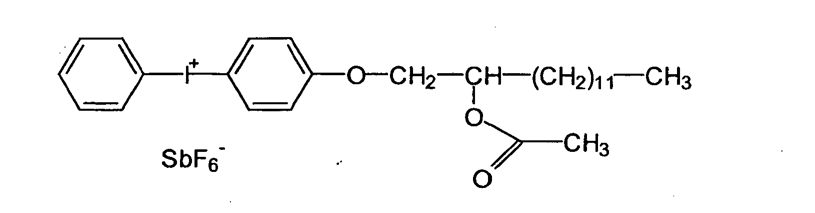 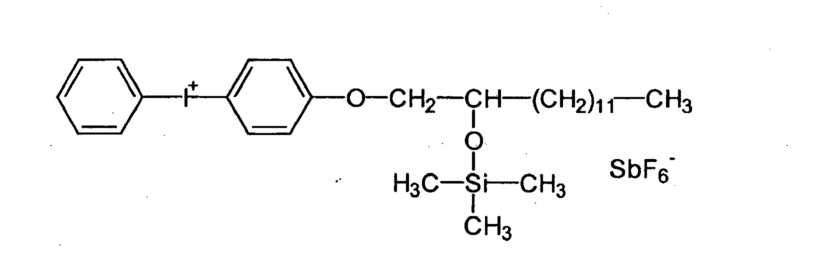 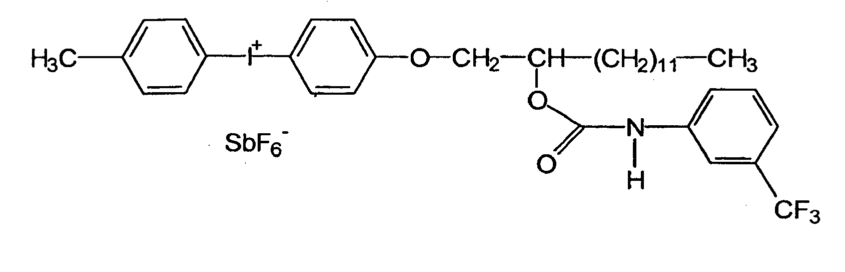 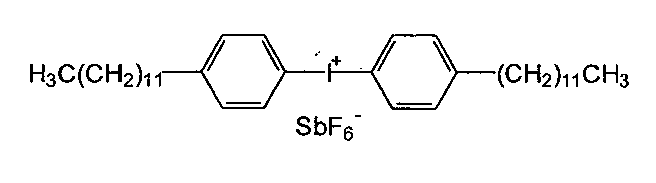 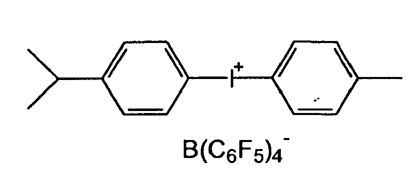 sind.

7. Kationisch strahlenhärtbare Siliconmassen enthaltend eine Lösung gemäß einem oder mehreren der Ansprüche 1 bis 6 als Photoinitiator.

8. Verwendung einer Lösung von Diaryljodoniumsalzen in hydroxyfunktionellen Polyalkylorganosiloxanen der allgemeinen Formel (IV) 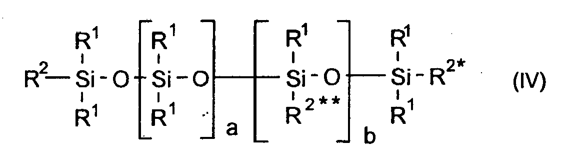 worin
a 0 bis 200 ist,
b 0 bis 50 ist,
R¹ im Molekül gleich oder verschieden ist und Alkylreste mit 1 bis 4 Kohlenstoffatomen bedeutet,
R² R^{2*}, R^{2**} gleich oder verschieden die folgende Bedeutung haben
R^{2a} unabhängig voneinander ausgewählte, gegebenenfalls substituierte Alkylreste mit 1 bis 20 Kohlenstoffatomen, gegebenenfalls substituierte Aryl- oder Aralkylreste,
R^{2b} unabhängig voneinander ausgewählte Reste der allgemeinen Formel
-R³[-O-(CₙH₂ₙO-)ₓH]_{z}
wobei
R³ ein gegebenenfalls substituierter, gegebenenfalls substituierter und/oder Etherbrücken enthaltender, z+1-wertiger Kohlenwasserstoffrest mit 2 bis 20 Kohlenstoffatomen, ein gegebenenfalls substituierter und/oder Etherbrücken enthaltender Aryl- oder Aralkylrest ist,
n 2, 3 oder 4 ist,
x 0 bis 100 ist,
z 1 bis 6 ist,
mit der Maßgabe, dass im durchschnittlichen Molekül jeweils mindestens ein Rest R², R^{2*} , R^{2**} die Bedeutung R^{2b} hat, als Lösungsmittel für Diaryljodoniumsalze.

## Claims

1. Solution of diaryliodonium salts in hydroxyl-functional polyalkylorganosiloxanes of the general formula (IV) 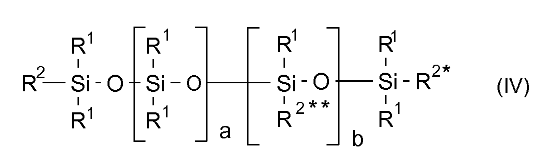 where
a is from 0 to 200,
b is from 0 to 50,
R¹ is identical or different at each occurrence in the molecule and denotes alkyl radicals having from 1 to 4 carbon atoms,
R², R^{2*} and R^{2**} are identical or different and have the following definition:
R^{2a} independently at each occurrence denotes selected, optionally substituted alkyl radicals having from 1 to 20 carbon atoms, optionally substituted aryl or aralkyl radicals,
R^{2b} independently at each occurrence denotes selected radicals of the general formula -R³[-O-(CₙH₂ₙO-)ₓH]_{z}
where
R³ is a z+1-valent hydrocarbon radical which optionally is substituted and/or contains ether bridges and has from 2 to 20 carbon atoms or is an aryl radical or aralkyl radical which optionally is substituted and/or contains ether bridges,
n is 2, 3 or 4,
x is from 0 to 100,
z is from 1 to 6,
with the proviso that in the average molecule in each case at least one radical R², R^{2*}, R^{2**} has the definition R^{2b}.

2. Solution according to Claim 1, **characterized in that**
a is a number in the range from 5 to 100, in particular from 5 to 80,
b is a number in the range from 0 to 10, in particular from 0 to 5,
n is a number in the range from 2 to 3,
x is a number in the range from 0 to 30, in particular from 0 to 10,
z is a number from 1 to 3.

3. Solution according to Claims 1 and 2, **characterized in that** the radical R¹ is a methyl radical.

4. Solution according to Claims 1 to 3, **characterized in that** the radical R^{2a} is at least one radical selected from the group consisting of methyl, ethyl, butyl, dodecyl, hexadecyl radical, aryl radicals, phenyl and naphthyl radical and/or (methyl)ethylphenyl radical.

5. Solution according to Claims 1 to 4, **characterized in that** the radical R³ is at least one radical selected from the group consisting of -CH₂-, -(-CH2)2-, -(CH₂)₃-, -(CH₂)₄-, -(CH₂)₆-, -(CH₂)₁₀-, -CH₂CH₂CH(OCH₃)CH₂-, phenyl, naphthyl or anthryl radical and aralkyl radicals, such as 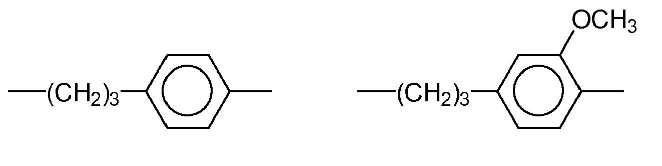 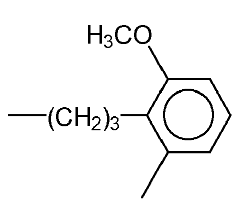 and radicals containing ether bridges, such as

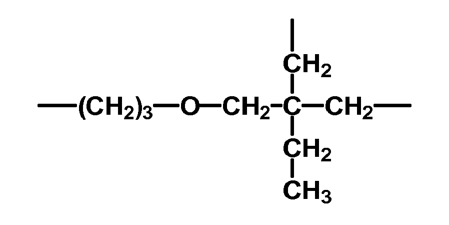

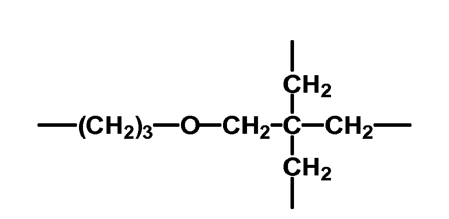

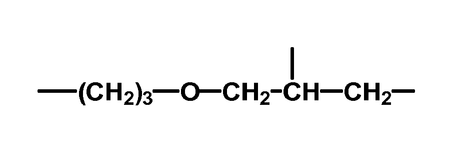

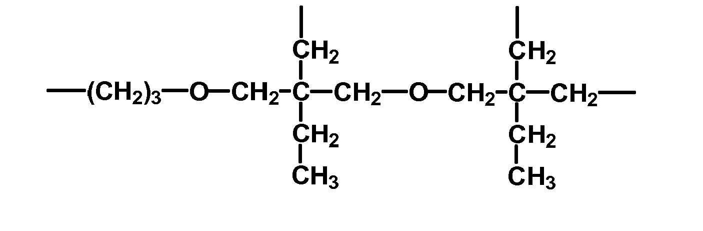

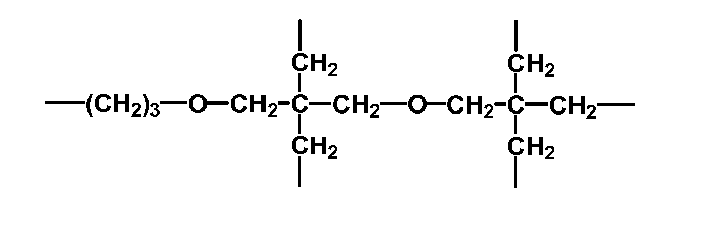

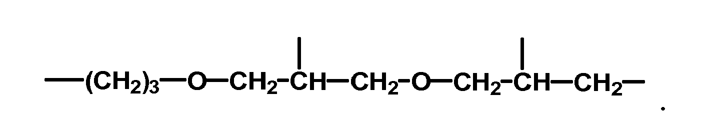

6. Solution according to Claims 1 to 5, **characterized in that** the diaryliodonium salts are a compound selected from the group consisting of

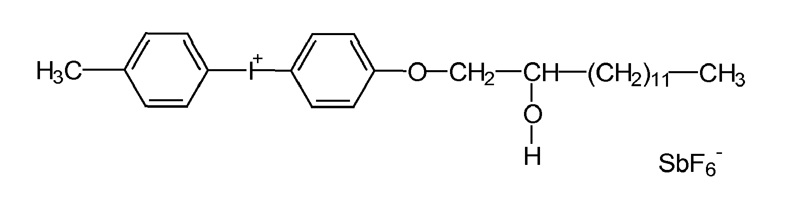

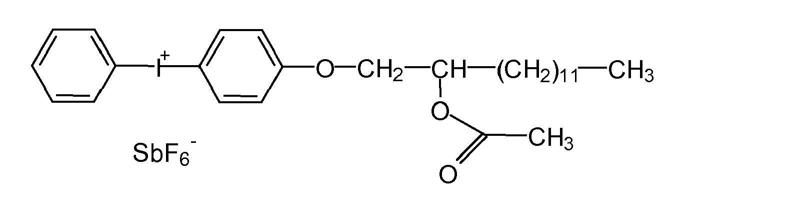

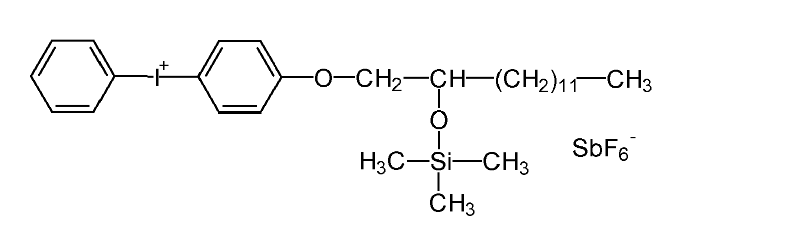

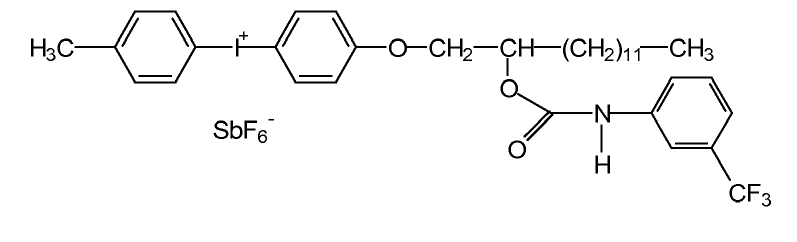

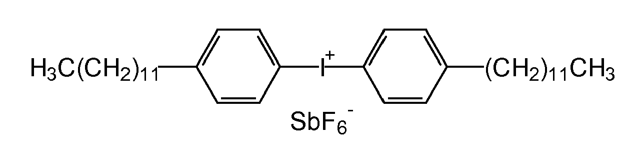

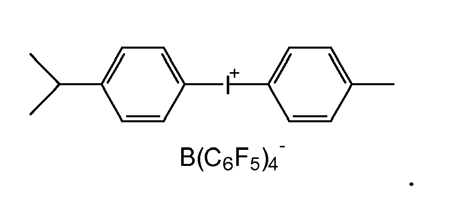

7. Cationically radiation-curable silicone compositions comprising a solution according to one or more of Claims 1 to 6 as photoinitiator.

8. Use of a solution of diaryliodonium salts in hydroxyl-functional polyalkylorganosiloxanes of the general formula (IV) 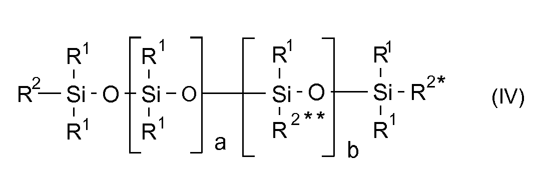 where
a is from 0 to 200,
b is from 0 to 50,
R¹ is identical or different at each occurrence in the molecule and denotes alkyl radicals having from 1 to 4 carbon atoms,
R², R^{2*} and R^{2**} are identical or different and have the following definition:
R^{2a} independently at each occurrence denotes selected, optionally substituted alkyl radicals having from 1 to 20 carbon atoms, optionally substituted aryl or aralkyl radicals,
R^{2b} independently at each occurrence denotes selected radicals of the general formula -R³[-O-(CₙH₂ₙO-)ₓH]_{z} where
R³ is a z+1-valent hydrocarbon radical which optionally is substituted and/or contains ether bridges and has from 2 to 20 carbon atoms or is an aryl radical or aralkyl radical which optionally is substituted and/or contains ether bridges,
n is 2, 3 or 4,
x is from 0 to 100,
z is from 1 to 6,
with the proviso that in the average molecule in each case at least one radical R², R^{2*}, R^{2**} has the definition R^{2b}, as solvent for diaryliodonium salts.

## Revendications

1. Solution de sels de diaryliodonium dans des polyalkylorganosiloxanes à fonction hydroxy, de formule générale (IV) 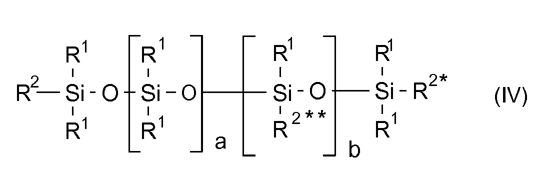 dans laquelle
a vaut de 0 à 200,
b vaut de 0 à 50,
R¹ est le même ou différent dans la molécule et représente des radicaux alkyle ayant de 1 à 4 atomes de carbone,
R², R²*, R²** identiques ou différents ont la signification suivante
R^{2a} représentent, choisis indépendamment les uns des autres, des radicaux alkyle éventuellement substitués ayant de 1 à 20 atomes de carbone, des radicaux aryle ou aralkyle éventuellement substitués,
R^{2b} représentent, choisis indépendamment les uns des autres, des radicaux de formule générale -R³[-O-(CₙH₂ₙO-)ₓH]_{z}
où
R³ est un radical hydrocarboné z+1-valent, ayant de 2 à 20 atomes de carbone, éventuellement substitué et/ou contenant des ponts éther, un radical aryle ou aralkyle éventuellement substitué et/ou contenant des ponts éther,
n est 2, 3 ou 4,
x vaut de 0 à 100,
z vaut de 1 à 6,
étant entendu que dans la molécule moyenne au moins un radical R², R^{2*}, R^{2**} a chaque fois la signification de R^{2b}.

2. Solution selon la revendication 1, **caractérisée en ce que**
a représente un nombre dans la plage de 5 à 100, en particulier de 5 à 80,
b représente un nombre dans la plage de 0 à 10, en particulier de 0 à 5,
n représente un nombre dans la plage de 2 à 3,
x représente un nombre dans la plage de 0 à 30, en particulier de 0 à 10,
z représente un nombre de 1 à 3.

3. Solution selon les revendications 1 et 2, **caractérisée en ce que** le radical R¹ représente un radical méthyle.

4. Solution selon les revendications 1 à 3, **caractérisée en ce que** le radical R^{2a} est au moins un radical choisi dans le groupe constitué par le radical méthyle, éthyle, butyle, dodécyle, hexadécyle, les radicaux aryle, le radical phényle, naphtyle et/ou le radical (méthyl)éthylphényle.

5. Solution selon les revendications 1 à 4, **caractérisée en ce que** le radical R³ est au moins un radical choisi dans le groupe constitué par -CH₂-, -(CH₂)₂-, -(CH₂)₃-, -(CH₂)₄-, -(CH₂)₆-, -(CH₂)₁₀-, -CH₂CH₂CH (OCH₃) CH₂-, le radical phényle, naphtyle ou anthryle et des radicaux aralkyle, tels que 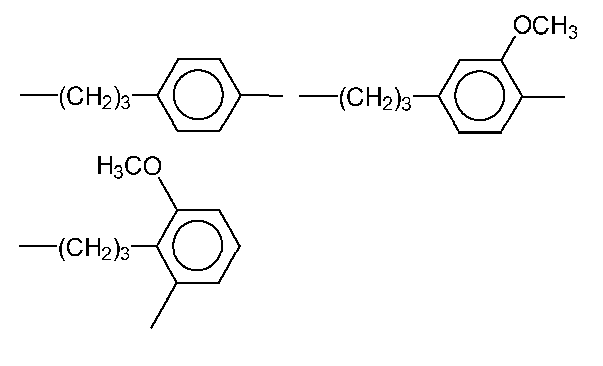 et des radicaux contenant des ponts éther, tels que

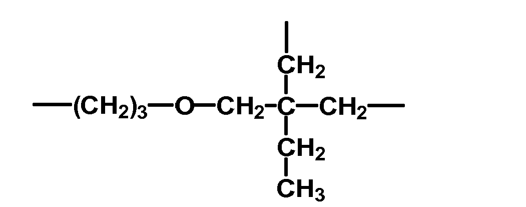

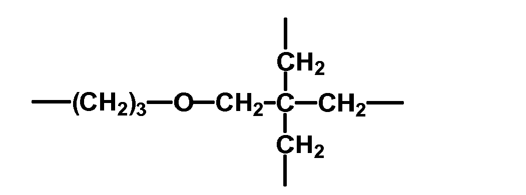

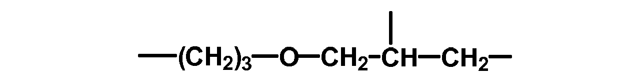

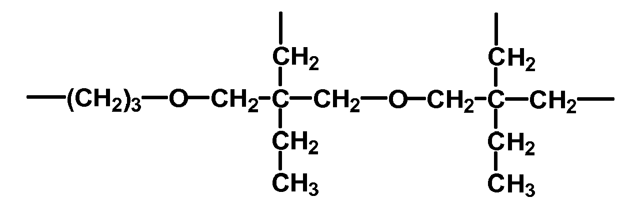

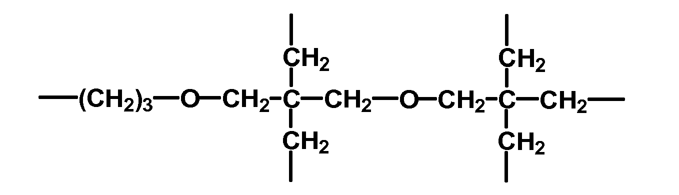

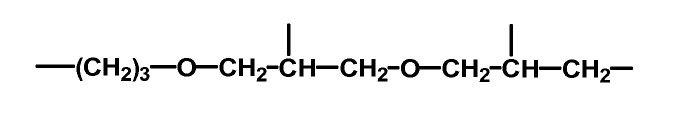

6. Solution selon les revendications 1 à 5, **caractérisée en ce que** les sels de diaryliodonium sont un composé choisi dans le groupe

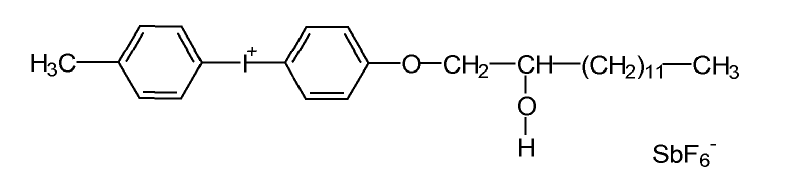

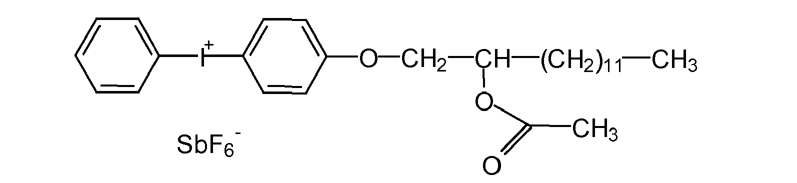

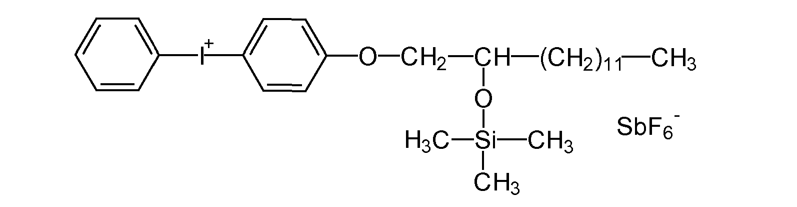

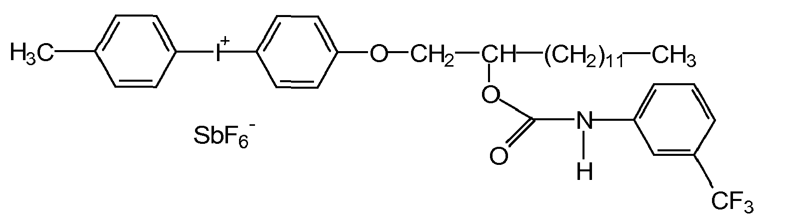

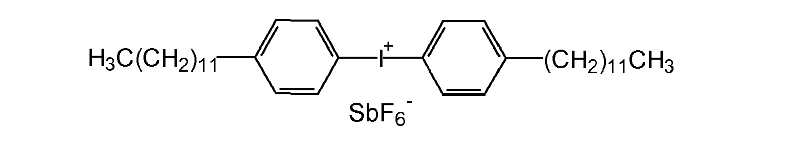

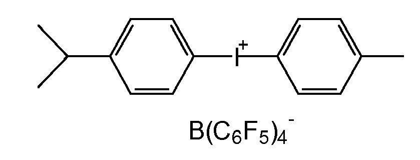

7. Matières silicone durcissables par irradiation par voie cationique, contenant une solution selon une ou plusieurs des revendications 1 à 6, en tant que photoamorceur.

8. Utilisation d'une solution de sels de diaryliodonium dans des polyalkylorganosiloxanes à fonction hydroxy de formule générale (IV) 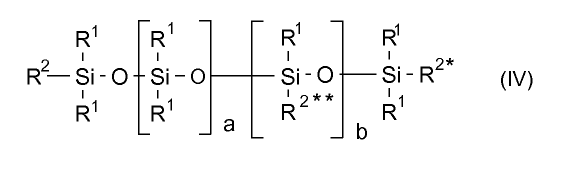 dans laquelle
a vaut de 0 à 200,
b vaut de 0 à 50,
R¹ est le même ou différent dans la molécule et représente des radicaux alkyle ayant de 1 à 4 atomes de carbone,
R², R^{2*}, R²** identiques ou différents ont la signification suivante
R^{2a} représentent, choisis indépendamment les uns des autres, des radicaux alkyle éventuellement substitués ayant de 1 à 20 atomes de carbone, des radicaux aryle ou aralkyle éventuellement substitués,
R^{2b} représentent, choisis indépendamment les uns des autres, des radicaux de formule générale -R³[-O-(CₙH₂ₙO-)ₓH]_{z}
où
R³ est un radical hydrocarboné z+1-valent, ayant de 2 à 20 atomes de carbone, éventuellement substitué et/ou contenant des ponts éther, un radical aryle ou aralkyle éventuellement substitué et/ou contenant des ponts éther,
n est 2, 3 ou 4,
x vaut de 0 à 100,
z vaut de 1 à 6,
étant entendu que dans la molécule moyenne au moins un radical R², R^{2*}, R^{2**} a chaque fois la signification de R^{2b}, en tant que solvant pour des sels de diaryliodonium.
